# EUROPEAN PATENT APPLICATION

(11) **EP 4 439 649 A1**
(43) Date of publication of application: **02.10.2024**
(21) Application number: 23165010.2
(22) Date of filing: 29.03.2023
(51) Int. Cl.: H01L 23/13, H01L 23/14, H01L 23/373, H05K 7/20, H01L 23/047, H01L 23/049, H01L 23/053, H01L 23/00, H01L 23/538, H01L 25/07

(54) **SUBSTRATE ARRANGEMENT**

(71) Applicant: Infineon Technologies AG, 85579 Neubiberg (DE)
(72) Inventor: HAMADI, Thomas, 44135 Dortmund (DE); HOHLFELD, Olaf, 29581 Warstein (DE)
(74) Representative: Westphal, Mussgnug & Partner, Patentanwälte mbB

(57) **Abstract**

A substrate arrangement comprises a generally square or rectangular base plate (12), a substrate (10) arranged on the base plate (12), the substrate (10) comprising a dielectric insulation layer (11) and a first metallization layer (111) attached to the dielectric insulation layer (11), and a connection layer (220) arranged between the substrate (10) and the base plate (12), wherein the base plate (12) consists of one of AlSiC, aluminum graphite, copper or aluminum, the dielectric insulation layer (11) is a ceramic layer, the substrate (10) has a maximum width (A) in a first horizontal direction (x) of at least 30mm, and a maximum length (B) in a second horizontal direction (z) perpendicular to the first horizontal direction (x) of at least 50mm, the connection layer (220) is a sinter layer, brazing solder layer, diffusion solder layer, or aluminum casting layer, and the substrate (10) has a generally square or rectangular form with four cut-off corners, or the substrate (10) has a round or oval shape.

## Description

### TECHNICAL FIELD

The instant disclosure relates to a substrate arrangement, in particular to a substrate arrangement for a power semiconductor module.

### BACKGROUND

Power semiconductor modules often include a substrate arranged in a housing. A semiconductor arrangement including a plurality of controllable semiconductor elements (e.g., two IGBTs in a half-bridge configuration) may be arranged on the substrate. The substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may be attached to a heat sink or to a base plate. A connection layer is generally arranged between the substrate and the base plate or heat sink. The connection layer forms a permanent connection between the substrate and the base plate or heat sink and is configured to conduct heat away from the substrate to the base plate or heat sink. During operation of the power semiconductor module, ageing processes may occur in some areas of the connection layer. The concerned areas of the connection layer may no longer be able to form a permanent connection between the respective sections of the substrate and the base plate or heat sink. Therefore, delamination may occur. In the concerned areas, heat can no longer be transferred away effectively from the substrate to the base plate or heat sink.

There is a need for a semiconductor module arrangement in which the described ageing processes do not occur such that heat may be conducted away effectively from the substrate to the base plate or heat sink over the entire area of the substrate.

### SUMMARY

A substrate arrangement includes a generally square or rectangular base plate, a substrate arranged on the base plate, the substrate including a dielectric insulation layer and a first metallization layer attached to the dielectric insulation layer, and a connection layer arranged between the substrate and the base plate, wherein the base plate consists of one of AlSiC, aluminum graphite, copper or aluminum, the dielectric insulation layer is a ceramic layer, the substrate has a maximum width in a first horizontal direction of at least 30mm, and a maximum length in a second horizontal direction perpendicular to the first horizontal direction of at least 50mm, the connection layer is a sinter layer, brazing solder layer, diffusion solder layer, or aluminum casting layer, and the substrate has a generally square or rectangular form with four cut-off corners, or the substrate has a round or oval shape.

The invention may be better understood with reference to the following drawings and the description. The components in the figures are not necessarily to scale, emphasis instead being placed upon illustrating the principles of the invention. Moreover, in the figures, like reference numerals designate corresponding parts throughout the different views.

### BRIEF DESCRIPTION OF THE DRAWINGS

Figure 1 is a cross-sectional view of a power semiconductor module arrangement.
Figure 2 is a top view of a substrate arrangement according to one example.
Figure 3 is a top view of a substrate arrangement according to another example.
Figure 4 is a top view of a substrate according to one example.
Figure 5 is a top view of a substrate arrangement according to another example.
Figure 6 is a top view of a substrate arrangement according to an even further example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to designate different "elements". That is, e.g., the existence of a "third element" does not require the existence of a "first element" and a "second element". An electrical line or electrical connection as described herein may be a single electrically conductive element, or may include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or may be included in a semiconductor chip. A semiconductor body has electrically connecting pads and includes at least one semiconductor element with electrodes.

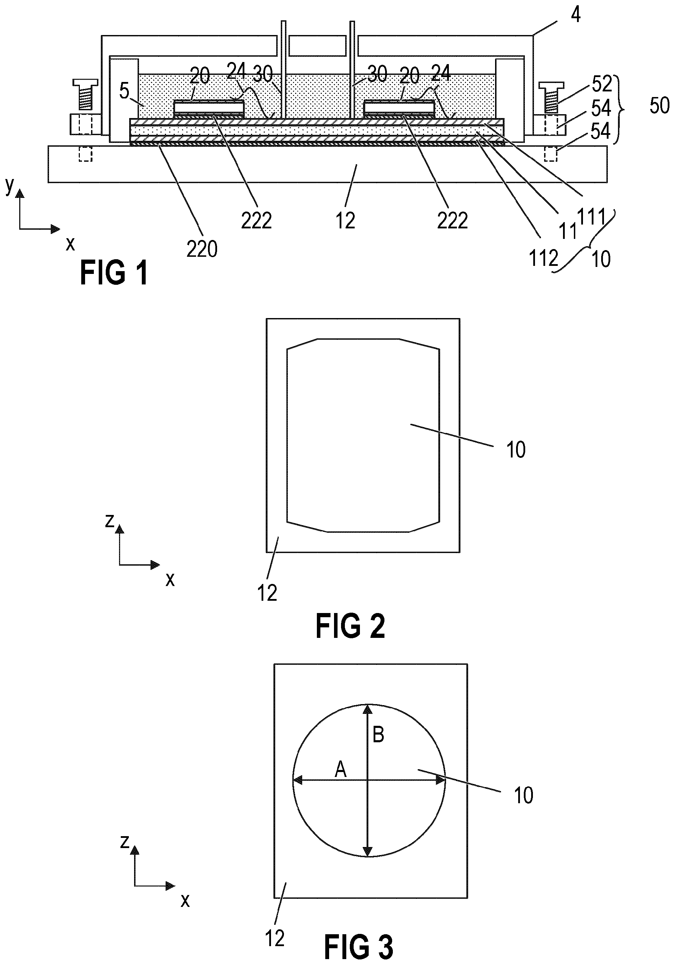

Referring to Figure 1, a cross-sectional view of an exemplary power semiconductor module is illustrated. The power semiconductor module includes a housing 4 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112. It is, however, also possible that the substrate 10 only comprises a first metallization layer 111, and that the second metallization layer 112 is omitted.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may be, e.g., a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm.

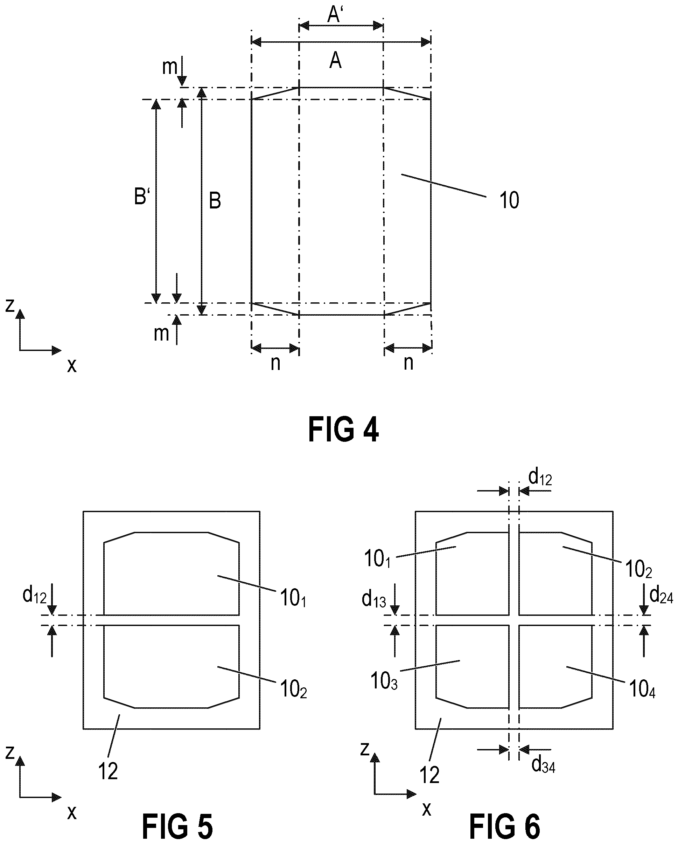

The substrate 10 may be a comparably large substrate. That is, a maximum width A of the substrate 10 in a first horizontal direction x may be at least 30mm, at least 50mm, or even at least 10cm (100mm). A maximum length B of the substrate 10 in a second horizontal direction z perpendicular to the first horizontal direction x may be at least 50mm, or even at least 10cm (see also Figure 4 in this regard).

The substrate 10 is arranged in the housing 4. In the example illustrated in Figure 1, the substrate 10 is arranged on a generally square or rectangular base plate 12, wherein the base plate 12 forms a ground surface of the housing 4. The housing 4 further comprises sidewalls and may further comprise a cover. In the example in Figure 1, only one large substrate 10 is arranged on the base plate 12. In some power semiconductor module arrangements, more than one smaller substrate 10 may be arranged on the same base plate 12 and in a single housing 4. The base plate 12 may comprise or consist of one of AlSiC, aluminum graphite, copper or aluminum, for example.

The substrate 10 may be connected to the generally square or rectangular base plate 12 by means of a hard connection layer 220. Such a hard connection layer 220 may be a solder layer, or a layer of a sintered metal powder, e.g., a sintered silver powder, for example. In particular, the connection layer 220 may be a sinter layer, a brazing solder layer, a diffusion solder layer, or an aluminum casting layer. Such connection layers are generally comparably hard connection layers 220, and are generally more fatigue resistant and reliable than other connection layers. Other processes such as, e.g., soft-soldering, generally result in significantly softer connection layers 220 which have significantly different properties as compared to hard connection layers 220. Such a large substrate 10, with a first metallization layer 111 mounted via a hard connection to a dielectric insulation layer 11, is sometimes referred to as an "integrated substrate".

One or more semiconductor bodies 20 may be arranged on the substrate 10. Each of the semiconductor bodies 20 arranged on the substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 of the example in Figure 1 is also a continuous layer. However, the first metallization layer 111, or the second metallization layer 112 or both can also be structured layers. "Structured layer" means that, e.g., the respective metallization layer 111, 112 is not a continuous layer, but includes recesses between different sections of the layer. Different semiconductor bodies 20 may be mounted on the same or different sections of the first metallization layer 111. Different sections of the first metallization layer 111 may have no electrical connection or may be electrically connected to one or more other sections using, e.g., bonding wires. Electrical connections may also include bonding ribbons, connection plates or conductor rails, for example, to name just a few examples. According to another example, the second metallization layer 112 can be omitted altogether. The one or more semiconductor bodies 20 may be electrically and mechanically connected to the substrate 10 by an electrically conductive connection layer 222. Such an electrically conductive connection layer 222 may be a solder layer, a layer of an electrically conductive adhesive, or a layer of a sintered metal powder, e.g., a sintered silver powder, for example.

The power semiconductor module may further include terminal elements 30. The terminal elements 30 are electrically connected to the substrate 10, e.g., to the first metallization layer 111 of the substrate 10, and form a contact element which provides an electrical connection between the inside and the outside of the housing 4. A first end of each of the terminal elements 30 may be electrically and mechanically connected to the first metallization layer 111 by an electrically conductive connection layer (not specifically illustrated). Such an electrically conductive connection layer may be a solder layer, a layer of an electrically conductive adhesive, or a layer of a sintered metal powder, e.g., a sintered silver powder, for example. A second end of each of the terminal elements 30 protrudes out of the housing 4 to allow the respective terminal element 30 to be electrically contacted from the outside. The cover of the housing 4 may comprise openings through which the terminal elements 30 may protrude such that their first end is inside the housing 4 and their second end is outside the housing 4. The terminal elements 30 may protrude vertically (i.e., perpendicular to a top surface of the substrate 10) out of the housing 4 when the housing 4 is arranged to surround the substrate 10. According to another example, terminal elements 30 may also protrude horizontally (parallel to the top surface of the substrate 10) through a sidewall of the housing 4.

A power semiconductor module may further include a casting compound 5, as is illustrated in the example of Figure 1. The casting compound 5 may consist of or include a silicone gel or may be a rigid molding compound, for example. The casting compound 5 may partly fill the interior of the housing 4, thereby covering the substrate 10 and the semiconductor bodies 20, and any other components and electrical connections 24 that are arranged on the substrate 10. Electrical connections 24 such as, e.g., bonding wires or bonding ribbons, may electrically couple the semiconductor bodies 20 to the first metallization layer 111, to other semiconductor bodies 20, or to any other components that may be arranged inside the housing 4. The terminal elements 30 may be partly embedded in the casting compound 5. At least the second ends of the terminal elements 30, however, may not be covered by the casting compound 5 and may protrude from the casting compound 5. The casting compound 5 is configured to protect the components and electrical connections inside the power semiconductor module arrangement, in particular inside the housing 4, from certain environmental conditions, mechanical damage and insulation faults.

When the semiconductor module arrangement is fully assembled, the substrate 10 is pressed onto the base plate 12 by means of the sidewalls of the housing 4, with the connection layer 220 arranged between the substrate 10 and the base plate 12, in order to provide a good thermal transition between the substrate 10 and the base plate 12. Further, the substrate 10 thereby may be kept in a desired position and may be prevented from shifting inside the housing 4, for example.

The housing 4 may comprise projections, for example, with threaded holes 54 formed therein. The base plate 12 may also comprise threaded holes 54. The housing 4 may be attached to the base plate 12 by means of screws or bolts 52, for example, that are inserted into the threaded holes 54. However, any other way of permanently mounting the housing 4 on the base plate 12 is generally also possible.

When a large ceramic substrate (length of at least 50mm or at least 100mm (10cm), width of at least 30mm, at least 50mm or at least 100mm (10cm)) is mounted on a generally square or rectangular base plate 12 consisting of one of AlSiC, aluminum graphite, copper or aluminum by means of a hard connection layer (e.g., sinter layer, brazing solder layer, diffusion solder layer, or aluminum casting layer), ageing processes may occur in some areas of the connection layer 220. The concerned areas of the connection layer 220 may no longer be able to form a permanent connection between the respective sections of the substrate 10 and the base plate 12. Therefore, delamination may occur. In the concerned areas, heat can no longer be transferred away effectively from the substrate 10 to the base plate 12. Such ageing processes, however, occur more often when large ceramic substrates are mounted to a base plate 12 by means of a sinter layer, brazing solder layer, diffusion solder layer, or aluminum casting layer (hard connection layer 220), and less often when soft solder is used. Ageing effects often occur at the corners of a square or rectangular substrate 10 and may spread a certain distance towards the center of the substrate 10. In some cases, where the hard connection between the first metallization layer 111 and the dielectric insulation layer 11 is particularly strong, ageing at the corners of the substrate 10 may cause, instead of delamination, separation within the dielectric insulation layer 11 itself, bringing with it the same detrimental effects associated with delamination.

Now referring to Figure 2, a substrate arrangement according to one example is schematically illustrated. Figure 2 provides a top view of a base plate 12 and a substrate 10 arranged thereon. The base plate 12 consists of one of AlSiC, aluminum graphite, copper or aluminum. The substrate 10 comprises a dielectric insulation layer 11 and a first metallization layer 111 attached to the dielectric insulation layer 11, the dielectric insulation layer 11 being a ceramic layer. The first metallization layer 111 is arranged on a surface of the dielectric insulation layer 11 that faces away from the base plate 12. A hard connection layer 220 is arranged between the substrate 10 and the base plate 12. In the top view of Figure 2, however, this connection layer 220 is not visible as it is covered by the substrate 10. The substrate 10 has a maximum width A in a first horizontal direction x of at least 30mm, at least 50mm, or even at least 10cm (100mm), and a maximum length B in a second horizontal direction z perpendicular to the first horizontal direction x of at least 10cm (see also Figure 4). The connection layer 220 is a sinter layer, brazing solder layer, diffusion solder layer, or aluminum casting layer. That is, the connection layer 220 is a comparably hard layer. The substrate 10 has a generally square or rectangular form with cut-off corners. That is, the resulting shape of the substrate 10 is octagonal.

As has been described above, ageing processes often occur in a hard connection layer 220 below the corners of a rectangular or square substrate 10. By cutting off the corners, the ageing processes can be significantly reduced or even entirely prevented. That is, the ageing processes are not relocated to other areas of the substrate 10. By cutting off the corners, therefore, the likelihood of delamination between the first metallization layer 111 and the dielectric insulation layer 11 is decreased, such that an equal heat transfer from the substrate 10 through the connection layer 220 to the base plate 12 occurs over the entire area of the laminated substrate 10. It should be noted that while removing these corner portion is particularly advantageous when implemented with substrates in which the first metallization layer 111 is mounted to the dielectric insulation layer 11 by a hard connection, this feature could also be advantageous in other substrates, for example, where a soft solder is used to mount the first metallization layer 111 to the dielectric insulation layer 11.

Optionally, these corner areas on the base plate which are not covered by the substrate 10 can be used for other purposes. Components which do not need to be cooled, such as wiring elements or other conductors, for example, could be located here.

A square or rectangular substrate 10 at its corners generally has right angles between its longitudinal and narrow sides. By cutting off the corners, no right angles exist anymore. Any angles formed by the sides of the octagonal substrate 10 are generally between 90° and 180°. That is, the substrate 10 with cut-off corners only comprises obtuse angles.

As is schematically illustrated in Figure 3, corners may even be avoided altogether. The substrate 10 instead may even have a round or oval shape.

Now referring to Figure 4, by cutting off one corner of a square or rectangular substrate 10, the maximum width A of the substrate 10 (distance between a first side and a second side opposite the first side) may be reduced by a first distance n, and the maximum length B of the substrate 10 (distance between a third side and a fourth side opposite the third side) may be reduced by a second distance m. That is, if all four corners of a square or rectangular substrate 10 have been cut off, a width A' of the resulting shortened third and fourth sides is A' = A - 2n, and a length B' of the resulting shortened first and second sides is B' = B - 2m. The first side is arranged parallel to the second side, the third side is arranged parallel to the fourth side, and an orientation of the first and second sides is generally perpendicular to an orientation of the third and fourth sides. The length B' of the shortened first side may equal the length B' of the shortened second side, and a width A' of the shortened third side may equal a width A' of the shortened fourth side. A first diagonal intermediate side connects the first side and the third side, a second diagonal intermediate side connects the first side and the fourth side, a third diagonal intermediate side connects the second side and the third side, and a fourth diagonal intermediate side connects the second side and the fourth side.

A ratio of the first distance n to the second distance m may be n/m > 1, or n/m > 2. A ratio of the first distance n to the maximum width A may be n/A > 1/5, or n/A > 1/4. A ratio of the maximum length B to the maximum width A may be B/A > 4/3. As has been described above, the maximum width A may be at least 30mm, or at least 50mm. In this way, any unwanted ageing effects can be efficiently avoided.

For a round substrate 10, the maximum width A equals the maximum length B and the maximum width and length may correspond to a diameter of the round substrate 10. The maximum width A and the maximum length B may differ from each other in an oval substrate 10 (oval substrate 10 not specifically illustrated).

Now referring to Figure 5, it is also possible that the substrate 10 is divided into a first sub-substrate 10i and a second sub-substrate 10₂. Each of the two sub-substrates 10₁, 10₂ has a generally square or rectangular form with two cut-off corners. The corners of the first sub-substrate 10₁ that face the second sub-substrate 10₂, however, remain intact (corners form a right angle), and the corners of the second sub-substrate 10₂ that face the first sub-substrate 10i remain intact (corners form a right angle). Such corners are generally not prone to the described ageing processes. A distance d₁₂ between the first sub-substrate 10i and the second sub-substrate 10₂ may be between 1mm and 5mm, for example.

Now referring to Figure 6, it is possible that the substrate 10 is divided into even more sub-substrates 10i. In Figure 6, four sub-substrates 10₁, 10₂, 10₃, 10₄ are exemplarily illustrated. One corner of each of the sub-substrates 10₁, 10₂, 10₃, 10₄ has been cut-off. That is, each of the four sub-substrates 10₁, 10₂, 10₃, 10₄ has a generally square or rectangular form with one cut-off corner. Those corners of a sub-substrate 10i, 10₂, 10₃, 10₄ that face another one of the sub-substrates 10₁, 10₂, 10₃, 10₄, however, remain intact (corners form a right angle), as they are generally not prone to the described ageing processes. A distance d₁₂, d₁₃, d₂₄, d₃₄ between each of the sub-substrates 10i, 10₂, 10₃, 10₄ and its neighboring sub-substrates 10₁, 10₂, 10₃, 10₄ may be between 1mm and 5mm, for example.

## Claims

1. A substrate arrangement comprising:
a generally square or rectangular base plate (12);
a substrate (10) arranged on the base plate (12), the substrate (10) comprising a dielectric insulation layer (11) and a first metallization layer (111) attached to the dielectric insulation layer (11); and
a connection layer (220) arranged between the substrate (10) and the base plate (12), wherein
the base plate (12) consists of one of AlSiC, aluminum graphite, copper or aluminum, the dielectric insulation layer (11) is a ceramic layer,
the substrate (10) has a maximum width (A) in a first horizontal direction (x) of at least 30mm, and a maximum length (B) in a second horizontal direction (z)
perpendicular to the first horizontal direction (x) of at least 50mm, the connection layer (220) is a sinter layer, brazing solder layer, diffusion solder layer,
or aluminum casting layer, and the substrate (10) has a generally square or rectangular form with four cut-off corners,
or the substrate (10) has a round or oval shape.

2. The substrate arrangement of claim 1, wherein the substrate (10) has a maximum width (A) in the first horizontal direction (x) of at least 50mm, or at least 10cm.

3. The substrate arrangement of claim 1 or 2, wherein the substrate (10) has an octagonal shape.

4. The substrate arrangement of claim 3, wherein
the substrate (10) comprises a first side and a second side arranged at a first distance in parallel to the first side, wherein the first distance equals the maximum width (A),
the substrate (10) comprises a third side and a fourth side arranged at a second distance in parallel to the third side, wherein the second distance equals the maximum length (B),
an orientation of the first and second sides is generally perpendicular to an orientation of the third and fourth sides,
a width (A') of the third and fourth sides is the maximum width (A) reduced by twice a first distance (n) such that A' = A - 2n, and
a length (B') of the first and second sides is the maximum length (B) reduced by twice a second distance (m) such that B' = B - 2m.

5. The substrate arrangement of claim 4, wherein a ratio of the first distance (n) to the second distance (m) is n/m > 1, or n/m > 2.

6. The substrate arrangement of claim 4 or 5, wherein a ratio of the first distance (n) to the maximum width (A) is n/A > 1/5, or n/A > 1/4.

7. The substrate arrangement of any of claims 4 to 6, wherein a ratio of the maximum length (B) to the maximum width (A) is B/A > 4/3.

8. The substrate arrangement of any of the preceding claims, wherein the substrate (10) is formed by a first sub-substrate (10₁) and a second sub-substrate (10₂), wherein each of the first and second sub-substrates (10₁, 10₂) has a generally square or rectangular form with two cut-off corners.

9. The substrate arrangement of claim 8, wherein the corners of the first sub-substrate (10i) that face the second sub-substrate (10₂) are intact, and the corners of the second sub-substrate (10₂) that face the first sub-substrate (10i) are intact and form a right angle.

10. The substrate arrangement of any of claims 1 to 7, wherein the substrate (10) is formed by four sub-substrates (10₁, 10₂, 10₃, 10₄), wherein each of the four sub-substrates (10₁, 10₂, 10₃, 10₄) has a generally square or rectangular form with one cut-off corner.

11. The substrate arrangement of claim 10, wherein the corners of a sub-substrate (10i, 10₂, 10₃, 10₄) that face another one of the sub-substrates (10₁, 10₂, 10₃, 10₄) are intact and form a right angle.
